# FASCICULE DE BREVET EUROPEEN

(11) **EP 3 496 213 B1**
(45) Date de publication et mention de la délivrance du brevet: **28.09.2022**
(21) Numéro de dépôt: 18207540.8
(22) Date de dépôt: 21.11.2018
(51) Int. Cl.: H01R 13/646, H01R 13/502, H01R 13/6474, H01R 43/048, H01R 13/6591, H01R 4/18, H01R 13/6593

(54) **PIECE D'ADAPTATION D'IMPEDANCE ÉLECTRIQUE POUR CONNECTEUR MONTÉ SUR CÂBLE A FILS ÉLECTRIQUES ISOLÉS**
IMPEDANZANPASSUNGSTEIL FÜR STECKVERBINDER, DER AUF EINEM KABEL MIT ISOLIERTEN ELEKTRISCHEN DRÄHTEN MONTIERT IST
ELECTRICAL IMPEDANCE MATCHING PART FOR CONNECTOR MOUNTED ON CABLE WITH INSULATED ELECTRICAL WIRES

(30) Priorité: 06.12.2017 FR 1761713
(43) Date de publication de la demande: 12.06.2019
(73) Titulaire: RAYDIALL, 38500 Voiron (FR)
(72) Inventeur: ANNEQUIN, Sébastien, 38500 Saint Nicolas de Macherin (FR)
(74) Mandataire: Nony

(56) Documents cités:
- EP-A1- 3 232 447
- WO-A1-2017/082021
- JP-A- 2004 071 404
- JP-A- 2004 079 377

## Description

### Domaine technique

La présente invention concerne le domaine de la connectique de transmission électrique et/ou de données.

Elle concerne plus particulièrement un connecteur dont les contacts centraux sont sertis à des extrémités de fils de câble électrique.

L'invention s'applique en particulier à la connectique pour transmission de données mettant en œuvre des câbles comprenant une paire de fils de transmission blindés ou non blindés.

L'invention s'applique de manière plus générale à tout type de connectique de transmission de signaux électriques et/ou de données et/ou de signaux radio-fréquences (RF).

Une application intéressante est la connectique pour véhicule automobile.

### Art antérieur

Dans le domaine de la connectique de transmission de signaux électriques et/ou de données et/ou de signaux radio-fréquences (RF), sont connus des connecteurs avec bloc isolant électrique dans lesquels sont pré-montés des contacts centraux destinés chacun à être serti autour d'une extrémité dénudée d'un fil de câble électrique.

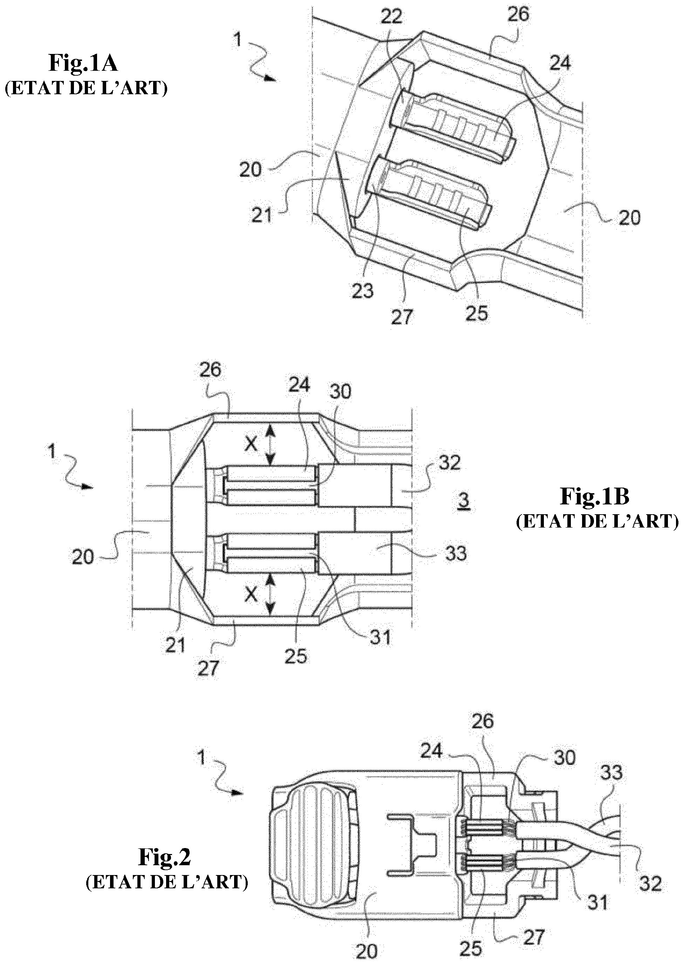

On a représenté aux figures 1A, 1B et 2, deux exemples de ce type de connecteurs actuellement existants.

Le connecteur 1 comprend tout d'abord un corps 20 dans lequel est logé un bloc isolant 20 à l'intérieur duquel sont pré-montés des contacts centraux 21, 22. Dans l'exemple illustré en figures 1A et 1B, le corps 20 est métallique, tandis que dans l'exemple de la figure 2, il est en matériau plastique isolant.

Pour assurer la liaison avec un câble électrique 3, les parties d' extrémité 23, 24 des contacts centraux 21, 22 sont serties autour d'extrémités dénudées d'âmes 30, 31 de fils d'un câble 3. Comme visible sur la figure 1B, chaque fil du câble 3 comprend une âme électriquement conductrice 30, 31 enrobée dans une couche d'isolant électrique 32, 33.

En outre, chaque corps 20 se prolonge à l'arrière au-delà des contacts centraux 21, 22 par le biais de parois de prolongement 26, 27 qui s'étendent de part et d'autre de la périphérie des contacts centraux 21, 22.

Ce type de connecteurs présente deux inconvénients majeurs qui découlent de l'espace restreint délimité entre les contacts centraux et les parois de prolongement 26, 27.

Cet espace restreint avec une distance X entre la périphérie des contacts centraux 21, 22 et les parois 26, 27, induit un passage très limité pour les mâchoires d'un outil de sertissage simultané des contacts centraux 21, 22.

Autrement dit, cet espace restreint ne permet pas d'utiliser des mâchoires de sertissage larges et robustes. Cela a pour conséquence de réduire la durée de vie des mâchoires de sertissage utilisées et aussi de provoquer des casses fréquentes des mâchoires dues à l'augmentation des contraintes résiduelles générées par les efforts de sertissage.

En outre, l'espace restreint délimité par les parois 26, 27 peut fortement dégrader la transmission du signal qui circule depuis les fils 30, 31 du câble 3 dans les contacts centraux 21, 22. En effet, du fait qu'il n'est pas physiquement possible de venir au plus près des contacts centraux 21, 22 sous peine de provoquer des casses de mâchoires, la distance X est suffisante pour induire une impédance élevée qui dégrade le signal électrique.

A titre d'exemple, dans le cas d'une connectique pour un véhicule automobile, avec l'exemple de connecteur 1 selon les figures 1 et 2, l'impédance dans la zone entre parois 26, 27 et contacts centraux 21, 22 peut être de l'ordre de 100 ohms.

Le document EP3232447 divulgue une pièce électriquement conductrice, destinée à garantir une adaptation d'impédance électrique lors de la connexion d'un connecteur avec un câble, comprenant :
- une partie avant dont la forme présente un profil extérieur continu et qui définit intérieurement un logement unique adapté pour loger la partie non dénudée de deux fils de câble
- une partie arrière, dans le prolongement de la partie avant,
pièce dans laquelle les parties avant et arrière de la pièce sont configurées pour diminuer la distance entre les âmes conductrices des fils et la masse électrique du connecteur de sorte à recréer une masse électrique au plus près du câble. Ce document divulgue aussi un procédé d'assemblage correspondant.

Il existe par conséquent un besoin pour améliorer les solutions de connectique à connecteur à contacts centraux à sertir autour d'extrémités dénudées de fils de câble de transmission de signaux électriques et/ou de données et/ou de signaux RF, notamment afin d'éliminer le risque de casse de mâchoires de sertissage et/ou de supprimer, à tout le moins de fortement réduire, la dégradation de transmission des signaux.

Le but de l'invention est de répondre au moins en partie à ce besoin.

### Exposé de l'invention

Pour ce faire, l'invention concerne une pièce électriquement conductrice selon la revendication 1.

L'inventeur a défini un connecteur avec deux demi-coques.

Après avoir défini ce connecteur, l'inventeur a analysé qu'en outre, l'espace entre les deux demi-coques et les fils dénudés pouvait permettre de monter une pièce électriquement conductrice d'adaptation d'impédance électrique, dont la forme épouserait au plus près les fils du câble électrique, afin de garantir une adaptation d'impédance optimale. Les ailettes sont essentiellement des logements cylindriques qui épousent au plus près la forme des isolants électriques des fils de câble. Cette pièce permet de contrôler précisément la distance entre les âmes conductrices des fils et la masse électrique du connecteur.

Ainsi, la pièce selon l'invention est destinée à adapter l'impédance de la connexion dans la zone entre l'extrémité de la gaine du câble et la zone de sertissage des contacts centraux. Pour ce faire, la pièce selon l'invention permet de diminuer la distance entre les âmes des fils électriques et la masse électrique du connecteur dans la zone entre l'extrémité de la gaine du câble et la zone de sertissage des contacts centraux.

Cette pièce d'adaptation d'impédance selon l'invention permet donc de recréer une masse électrique au plus près du câble comme le font un feuillard et/ou une tresse métallique initialement présent(s) dans le câble et enroulé(s) autour des isolants électriques des fils mais qui est (sont) dénudé(s) pour les opérations de sertissage des extrémités de fils dans des contacts centraux.

En effet, l'impédance dans un connecteur est déterminée par l'espace compris entre d'une part la masse électrique définie par le corps formant contact de masse du connecteur ou par les deux demi-coques assemblées entre elles du connecteur tel que décrit précédemment et d'autre part, l'âme électriquement conductrice de chacun des fils du câble qui véhiculent un signal.

Plus cet espace entre la masse électrique et l'âme de chaque fil à travers lequel le signal est transmis, est important, plus l'impédance va être élevée.

Or, la position optimale du câble correspond à une position de masse électrique qui épouse au plus près les fils comme on retrouve dans la construction même du câble, qui intègre un feuillard ou une tresse métallique enroulé(e) autour de la couche isolante des fils du câbles pour garantir leur impédance.

Mais, lorsque que l'on veut dénuder les fils afin de procéder aux opérations de sertissage avec les contacts centraux, il est nécessaire d'enlever localement le feuillard ou la tresse pour pouvoir écarter les fils l'un de l'autre.

De ce fait, une fois le câble monté dans un corps formant contact de masse du connecteur ou entre les deux demi-coques, l'impédance qui en résulte se calcule sur la distance entre l'âme conductrice de chacun des fils et la masse électrique (corps formant contact de masse ou deux demi-coques).

Or, cette distance est relativement importante, d'où une impédance augmentée.

Ainsi, grâce à la pièce d'adaptation d'impédance selon l'invention, on diminue fortement l'impédance électrique excessive qui est due au dénudage du feuillard et/ou de la tresse métallique.

Par conséquent, la pièce d'adaptation selon l'invention permet de conserver l'intégrité du signal électrique provenant du câble vers le sous-ensemble du connecteur ou vers un connecteur classique.

Pour garantir au mieux la continuité du signal électrique, cette pièce d'adaptation présente une zone de contact physique avec la masse électrique du corps ou des deux demi-coques. Cette zone de contact pourra être obtenue par compression du corps ou des deux demi-coques sur ladite pièce ou par soudage entre la pièce d'adaptation et le corps ou des deux demi-coques.

Un avantage subséquent induit par la pièce d'adaptation selon l'invention est qu'elle peut être utilisée comme guide des fils du câble pour bien positionner leurs âmes conductrices par rapport aux contacts centraux avant réalisation de leur sertissage. Cela augmente la facilité à l'assemblage entre câble et connecteur.

L'invention a enfin pour objet un ensemble selon la revendication 4.

Les ailettes sont essentiellement des logements cylindriques qui épousent au plus près la forme des isolants électriques des fils de câble.

Selon un premier mode de réalisation, l'ensemble comprend deux demi-coques électriquement conductrices assemblées entre elles, autour à la fois du corps conducteur, des contacts centraux, d'une partie du câble au-delà des extrémités dénudées des fils sertis, ainsi que de la pièce d'adaptation qui est en contact électrique avec au moins l'une des deux demi-coques.

Selon un deuxième mode de réalisation, l'ensemble comprend un corps électriquement conducteur, formant contact de masse positionné autour à la fois du corps conducteur, des contacts centraux, d'une partie du câble au-delà des extrémités dénudées des fils sertis, ainsi que de la pièce d'adaptation en contact électrique avec le corps.

Selon ce deuxième mode, et une variante avantageuse, la pièce d'adaptation est en contact physique avec le contact de masse, afin d'assurer la continuité électrique de la masse.

L'invention concerne enfin un procédé de montage selon la revendication 8.

### Description détaillée

D'autres avantages et caractéristiques de l'invention ressortiront mieux à la lecture de la description détaillée d'exemples de mise en œuvre de l'invention faite à titre illustratif et non limitatif en référence aux figures suivantes parmi lesquelles :
- les figures 1A et 1B sont des vues en perspective partielle d'un premier exemple de connecteur à contacts centraux à sertir selon l'état de l'art;
- la figure 2 est une reproduction photographique en perspective d'un deuxième exemple de connecteur à contacts centraux à sertir selon l'état de l'art;
- la figure 3 est une vue en perspective d'un exemple de sous-ensemble de connecteur à contacts centraux à sertir;
- la figure 4 est une vue perspective et en éclaté d'un connecteur avec le sous ensemble et les deux demi-coques à assembler entre elles autour du corps conducteur du sous-ensemble et d'un câble dont les fils sont à sertir à l'intérieur des contacts centraux du sous-ensemble;
- la figure 5 est une vue perspective du connecteur selon la figure 4 mais avec les deux demi-coques assemblées entre elles par sertissage;
- les figures 6A à 6E sont des vues en perspective montrant les différentes étapes de montage d'un connecteur à un câble à fils à sertir à l'intérieur des contacts centraux du sous-ensemble de connecteur;
- la figure 7 est une vue en perspective montant le connecteur monté sur le câble à l'issue des étapes selon les figures 6A à 6E ;
- la figure 8 est une vue en coupe longitudinale de la figure 7, réalisée au niveau des parties des contacts centraux serties autour des fils dénudés du câble ;
- la figure 9 est une vue en perspective de l'arrière d'une pièce d'adaptation d'impédance électrique selon l'invention, avant et après son montage dans un corps formant contact de masse électrique de connecteur ou dans l'espace entre les deux demi-coques assemblées entre elles;
- les figures 10A à 10G sont des vues en perspective montrant les différentes étapes de montage d'un connecteur et d'une pièce d'adaptation d'impédance selon l'invention à un câble à fils à sertir à l'intérieur des contacts centraux du sous-ensemble de connecteur;
- les figures 11 et 12 sont des vues en perspective montrant une variante de réalisation des deux demi-coques conformes à l'invention ;
- les figures 13A et 13B sont des vues en perspective montrant les étapes d'un assemblage entre elles par sertissage des deux demi-coques selon les figures 11 et 12 autour du corps conducteur et des contacts centraux du connecteur ainsi qu'autour du câble à fils sertis dans les contacts centraux;
- la figure 14 est une vue en perspective montant le connecteur monté sur le câble à l'issue des étapes selon les figures 13A et 13B ;
- les figures 15A à 15C sont des vues en perspective montrant les différentes étapes de préparation d'un câble à fils à sertir;
- la figure 16 est une vue en coupe longitudinale d'un câble à l'issue des étapes selon les figures 15A à 15C, avec insertion d'une pièce d'adaptation d'impédance selon l'invention ;
- La figure 16A est une vue en coupe transversale d'un câble selon la figure 16 ;
- la figure 17 est une vue en coupe longitudinale d'un câble selon l'état de l'art, c'est-à-dire sans pièce d'adaptation d'impédance selon l'invention ;
- la figure 17A est une vue en coupe transversale d'un câble selon la figure 17.

Les figures 1A, 1B et 2 relatives à un connecteur selon l'état de l'art ont été décrites dans le préambule. Elles ne seront donc pas commentées ci-après.

On précise ici dans l'ensemble de la présente demande, les termes « inférieur», « supérieur », « dessus », « dessous », « intérieur », « extérieur », « « interne », « externe» sont à comprendre par référence à un connecteur selon l'invention en configuration sensiblement à l'horizontal.

Un connecteur 1 selon l'invention comprend tout d'abord un sous-ensemble 2 pré-monté.

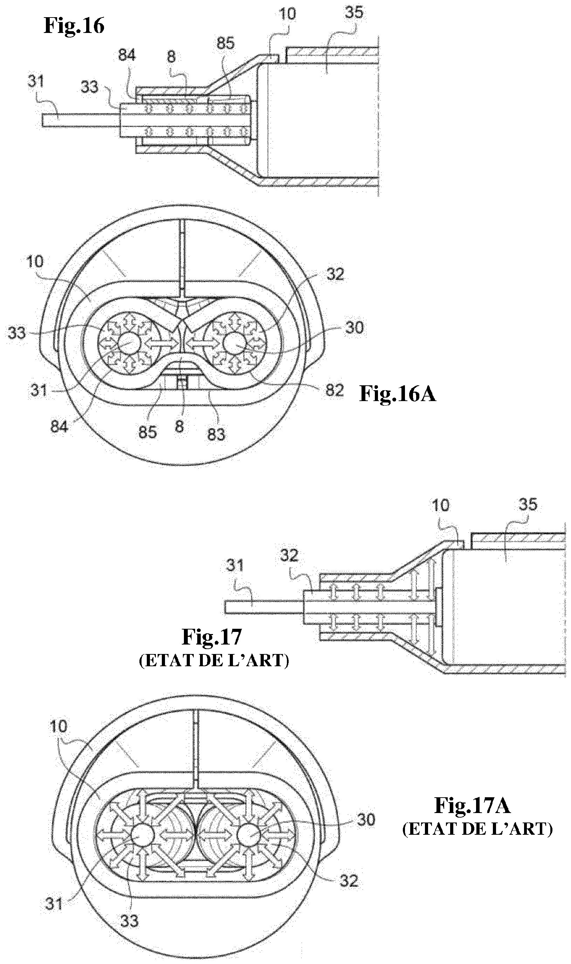

Ce sous-ensemble 2 est destiné à être relié et monté sur un câble 3 à fils isolés 30, 31 les uns des autres comme illustré en figures 16A à 16C. Plus précisément, dans les exemples illustrés, ce câble 3 comprend deux fils constitués chacun d'une âme électriquement conductrice 30, 31 enrobée d'une couche d'isolant électrique 32, 33, et logés dans une gaine de protection 36. Les fils sont par construction entourés d'un feuillard métallique 34 et d'une tresse métallique 35 se terminant en bout de câble 3.

Ce sous-ensemble 2 de connecteur comprend un corps métallique 20 maintenant en son sein un bloc isolant électrique 21 à l'intérieur duquel sont insérés des contacts centraux 22, 23 comprenant des parties de sertissage 24, 25 qui s'étendent en étant déportés en saillie vers l'arrière du bloc isolant 21.

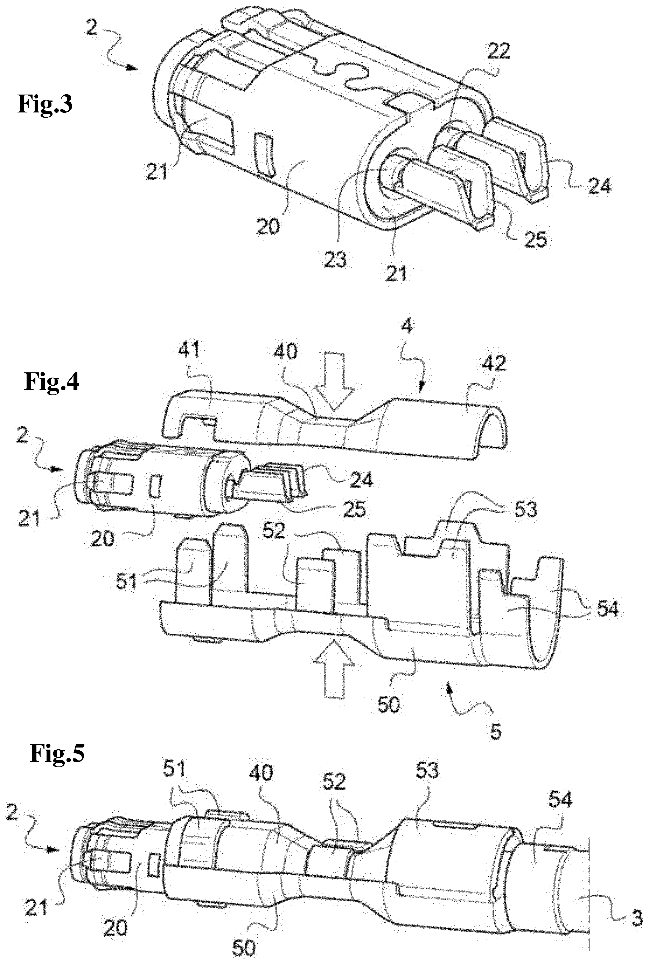

Comme visible sur la figure 3, à l'état pré-monté et avant sertissage des contacts centraux 22, 23, les parties de sertissage 24, 25 de ces derniers en saillie sont complètement dégagés des autres composants 20, 21 du sous-ensemble 2. Autrement dit, leur périphérie est libre de toute pièce environnante, ce qui va permettre de réaliser le sertissage des parties 24, 25 avec des mâchoires de sertissage de grande largeur, comme expliqué par la suite.

Comme illustré en figure 4, le connecteur 1 comprend également deux demi-coques métalliques 4, 5 destinées à être assemblées l'une à l'autre autour à la fois du corps conducteur 20, des contacts centraux 22, 23 et d'une partie du câble au-delà des extrémités dénudées des âmes de fils 30, 31, une fois que les parties de sertissage 24, 25 des contacts sont serties autour des extrémités dénudées des fils.

La demi-coque supérieure 4 comprend un corps creux 40 dont l'avant présente des échancrures 41.

La demi-coque inférieure 5 comprend un corps creux 50 qui comprend respectivement de l'avant à l'arrière, une première 51, deuxième 52 et troisième 53 paires de pattes de fixation par sertissage au corps 40 de la demi-coque supérieure 4. Les première et deuxième paires 51, 52 de sertissage ont pour fonction de réaliser l'assemblage entre les deux corps 40, 50 tandis que la troisième paire 53 a en outre pour fonction de réaliser une mise à la masse des deux demi-coques 4, 5 en compression sur la tresse métallique 35 au niveau de la partie arrière 42 de la demi-coque supérieure 4.

La demi-coque supérieure 5 comprend en outre, à l'arrière de son corps creux 50, une paire de pattes 54 de fixation par sertissage autour de la gaine 36 du câble.

La figure 5 montre un connecteur 1 selon l'invention avec les deux demi-coques 4, 5 assemblées entre elles par les différentes paires de pattes 51, 52, 53, 54 serties autour du corps conducteur 20 et des contacts centraux 22, 23 sertis du sous-ensemble 2 ainsi qu'autour du câble 3.

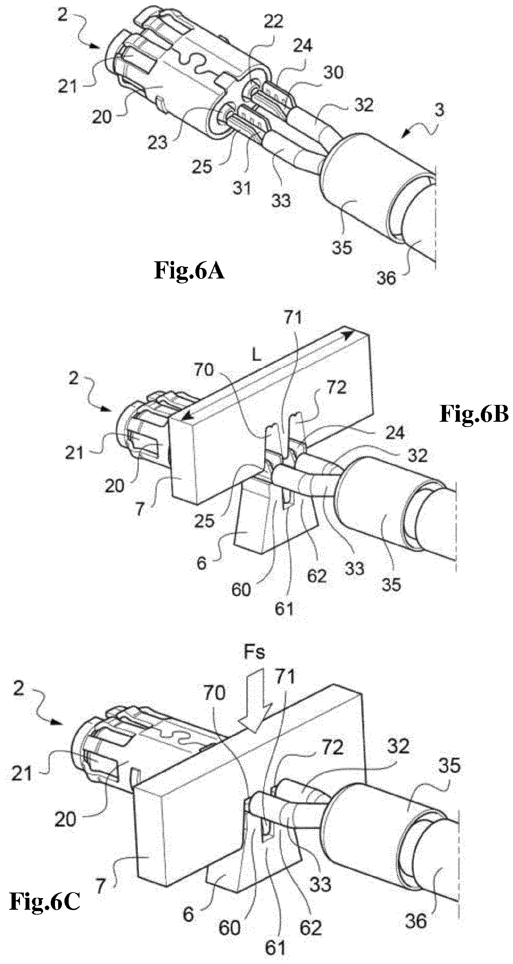

On décrit maintenant en référence aux figures 6A à 6E, les différentes étapes de montage d'un câble 3 à un connecteur 1.

Etape a/ : Après avoir dénudé les extrémités des âmes de fils 30, 31 du câble et les avoir écartés l'un de l'autre, on vient mettre en place chacune de ces extrémités dans la partie de sertissage 24, 25 d'un contact central pré-monté 22, 23 du sous-ensemble 2 (figure 6A).

Etape b/ : On procède alors au positionnement des contacts centraux 22, 23 sur une mâchoire inférieure de sertissage 6 (figure 6B).

Plus précisément, les parties de sertissage 24, 25 des contacts centraux 22, 23 sont positionnées en appui contre des butées 60, 62 de la mâchoire inférieure 6 qui sont séparées par une gorge 61.

Etape c/ : On effectue alors le déplacement d'une mâchoire supérieure de sertissage 7 vers et autour de la mâchoire inférieure de sertissage 6 selon un effort de sertissage Fs, de sorte à réaliser le sertissage des contacts centraux 21, 22 autour des extrémités dénudées de fil 30, 31 (figure 6C).

Plus précisément, la mâchoire supérieure 7 comprend deux gorges de sertissage 70, 72 séparées par une nervure 71 de forme complémentaire à la gorge 61 de la mâchoire inférieure 6. Lors du déplacement de la mâchoire supérieure 7 vers la mâchoire inférieure 6, les gorges de sertissage viennent déformer plastiquement les parties de sertissage 24, 25 des contacts centraux 22, 23 et les rabattre autour d'elle-même en venant emprisonner les parties dénudées d'âmes 30, 31 des fils.

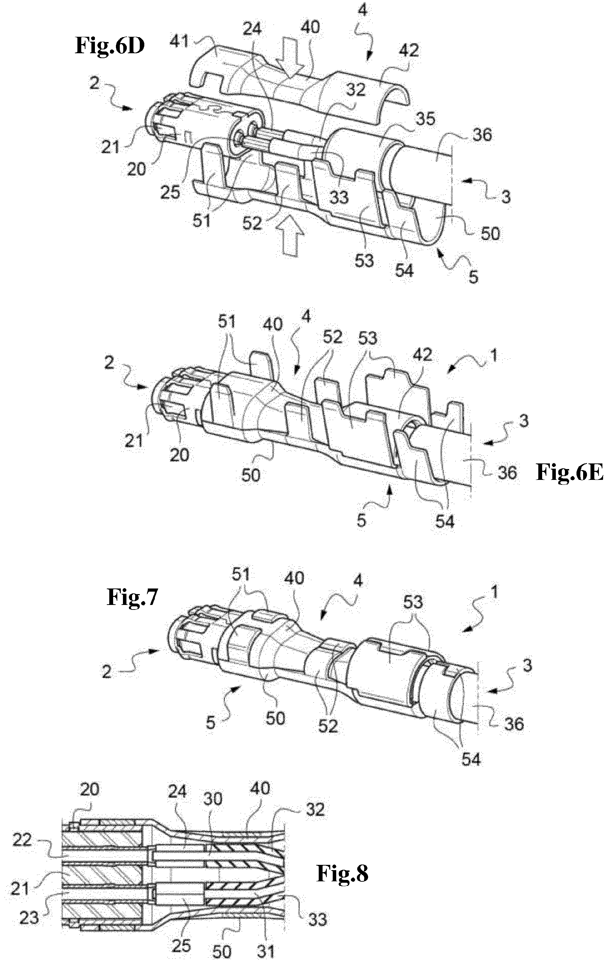

Etape d/ : Une fois réalisé le sertissage des parties dénudées d'âmes 30, 31 des fils dans les contacts centraux 22, 23, on vient positionner les deux demi-coques 4, 5 autour du corps conducteur 20 et des contacts centraux 22, 23 sertis et d'une partie du câble au-delà des extrémités dénudées des fils (figures 6D, 6E).

Etape e/ : On termine alors l'assemblage du connecteur 1 au câble 3, en réalisant l'assemblage par sertissage des deux demi-coques 4, 5 entre elles.

Plus précisément, on sertit en les déformant de manière plastique les différentes paires de pattes de sertissage 51, 52, 53, 54 de la demi-coque inférieure 5 pour les rabattre respectivement autour du corps 40 de la demi-coque supérieure 4, et de la tresse métallique 35 du câble 3 (figure 7). Le câble 3 est alors compressé par la paire de patte de sertissage 53 et la partie arrière 42 de la demi-coque supérieure 4 et retenu mécaniquement par la paire arrière de sertissage 54.

La figure 8 met en évidence qu'une fois l'assemblage réalisé, l'intérieur des deux demi-coques 4, 5 épouse au plus près les parties arrière 24, 25 des contacts centraux 22, 23 et des âmes 30, 31 des fils avec leurs isolants électriques autour 32, 33. L'impédance électrique est ainsi adaptée de manière optimale, ce qui permet une meilleure transmission des signaux véhiculés depuis ou vers les fils 30, 31 du câble 3, avec une augmentation des performances électriques.

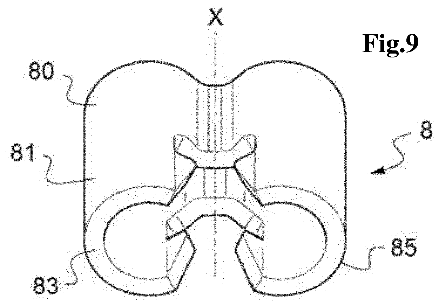

Pour renforcer encore l'adaptation d'impédance, les inventeurs ont conçu la pièce d'adaptation d'impédance 8 telle que montrée en figures 9. Une fois mise en place à l'intérieur de l'espace à l'arrière, entre les deux demi-coques métalliques 4, 5, cette pièce 8 permet de créer une continuité de masse électrique au plus près du câble 3, afin de conserver l'intégrité des signaux électriques véhiculés depuis ou vers les fils 30, 31 du câble 3.

Cette pièce d'adaptation d'impédance 8 s'étend selon un axe longitudinal X et comprend :
- une partie avant 80 comprenant deux logements 82, 84 dont la forme présente un profil extérieur continu et qui définit intérieurement deux logements cylindriques 82, 84 adaptés chacun pour loger la partie d'un fil de câble non dénudée 32, 33;
- une partie arrière 81, dans le prolongement de la partie avant, dont la forme présente un profil extérieur discontinu délimité par des ailettes 83, 85 de forme complémentaire à celle de la partie du fil de câble non dénudée 32, 33.

Dans l'exemple illustré, les logements cylindriques 82, 84 sont jointifs par un espace ouvert. On peut bien entendu prévoir d'avoir deux logements 82, 84 distincts séparés par une nervure.

Les ailettes 83, 85 sont essentiellement des logements cylindriques qui épousent au plus près la forme des isolants électriques des fils de câble 32, 33.

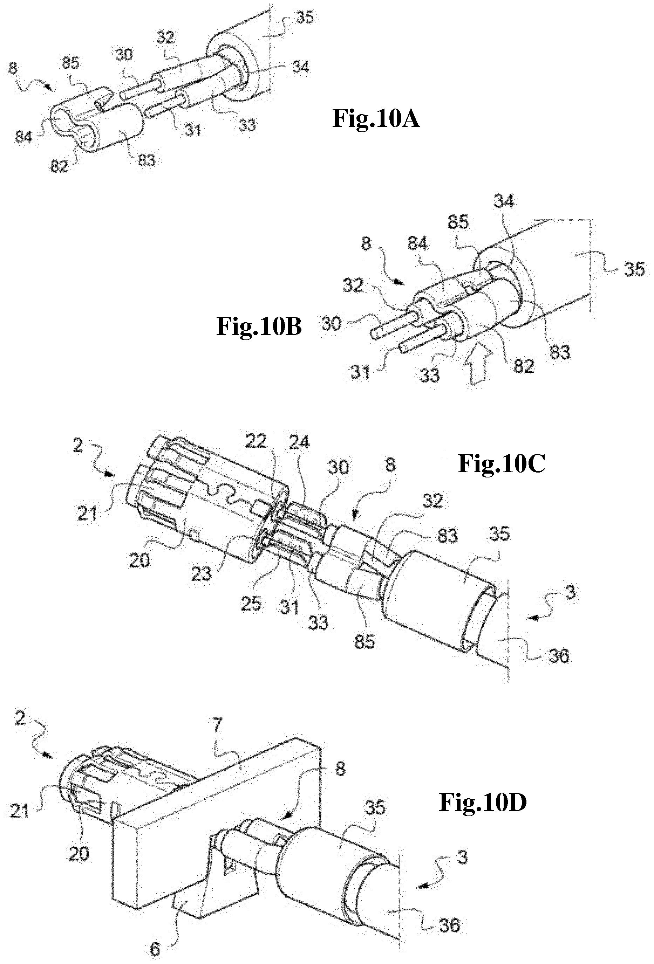

On décrit maintenant en référence aux figures 10A à 10G, les différentes étapes de montage d'un câble 3 à un connecteur 1 selon l'invention avec insertion d'une pièce d'adaptation d'impédance 8 selon l'invention.

Etape a'/ : Après avoir dénudé les extrémités des âmes de fils 30, 31 du câble et les avoir écartés l'un de l'autre, on vient mettre en place la pièce 8 autour des âmes de fils 30, 31 (figure 10A).

Plus précisément, les logements cylindriques 82, 84 épousent au plus près la forme des isolants électriques 32, 33 des fils de câble.

Etape a" : On vient alors mettre en compression la pièce d'adaptation 8 autour des isolants 32, 33. Plus précisément, à l'avant 80 de la pièce, on vient serrer l'espace entre les logements cylindriques 82, 84 de façon à les rapprocher et les mettre en contact direct avec les isolants 32, 33, et à l'arrière 81, on vient rabattre en les déformant les ailettes 83, 85 sur les isolants 32, 33 afin qu'elles épousent avec contact les courbures de ces derniers (figure 10B).

Etape a‴ : On vient alors positionner chacune de ces extrémités dénudées des âmes de fils 30, 31 dans la partie de sertissage 24, 25 d'un contact central 22, 23 du sous-ensemble 2, la pièce d'adaptation étant comprimé à l'arrière (figure 10C).

Etape b'/ : On procède alors au positionnement des contacts centraux 22, 23 sur une mâchoire inférieure de sertissage 6, avec la pièce 8 dégagée de la mâchoire 6 (figure 10D).

Plus précisément, les parties de sertissage 24, 25 des contacts centraux 22, 23 sont positionnées en appui contre des butées 60, 62 de la mâchoire inférieure 6 qui sont séparées par une gorge 61.

Etape c'/ : On effectue alors le déplacement d'une mâchoire supérieure de sertissage 7 vers et autour de la mâchoire inférieure de sertissage 6 selon un effort de sertissage Fs, de sorte à réaliser le sertissage des contacts centraux 21, 22 autour des extrémités dénudées d'âmes de fil 30, 31 (figure 10D).

Plus précisément, la mâchoire supérieure 7 comprend deux gorges de sertissage 70, 72 séparées par une nervure 71 de forme complémentaire à la gorge 61 de la mâchoire inférieure 6. Lors du déplacement de la mâchoire supérieure 7 vers la mâchoire inférieure 6, les gorges de sertissage viennent déformer plastiquement les parties de sertissage 24, 25 des contacts centraux 22, 23 et les rabattre autour d'elle-même en venant emprisonner les parties dénudées d'âmes 30, 31 des fils et sans endommager la pièce d'adaptation en dehors de l'espace entre mâchoires 6, 7.

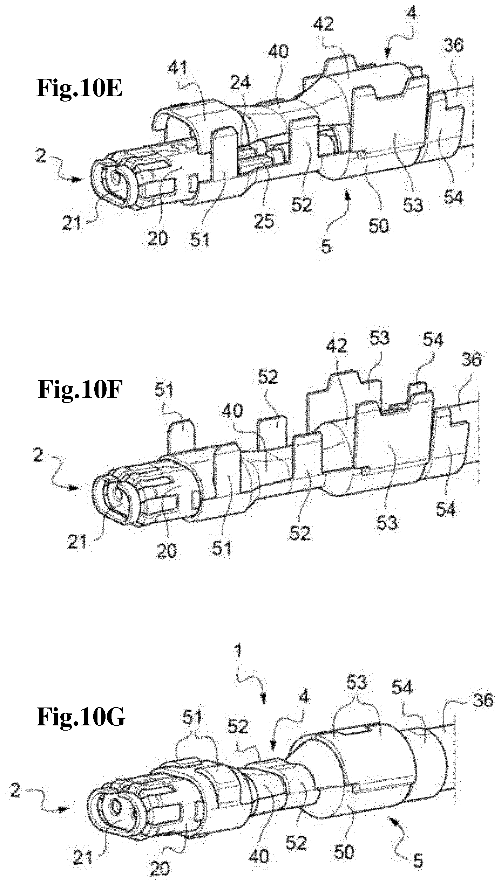

Etape d'/ : Une fois réalisé le sertissage des parties dénudées d'âmes 30, 31 des fils dans les contacts centraux 22, 23, on vient positionner les deux demi-coques 4, 5 autour du corps conducteur 20 et des contacts centraux 22, 23 sertis et d'une partie du câble au-delà des extrémités dénudées des fils (figures 10E, 10F).

Etape e'/ : On termine alors l'assemblage du connecteur 1 au câble 3, en réalisant l'assemblage par sertissage des deux demi-coques 4, 5 entre elles.

Plus précisément, on sertit en les déformant de manière plastique les différentes paires de pattes de sertissage 51, 52, 53, 54 de la demi-coque inférieure 5 pour les rabattre respectivement autour du corps 40 de la demi-coque supérieure 4, et de la tresse métallique 35 du câble 3 (figure 10G). Le câble 3 est alors compressé par la paire de pattes de sertissage 53 et retenu mécaniquement par la paire arrière de sertissage 54.

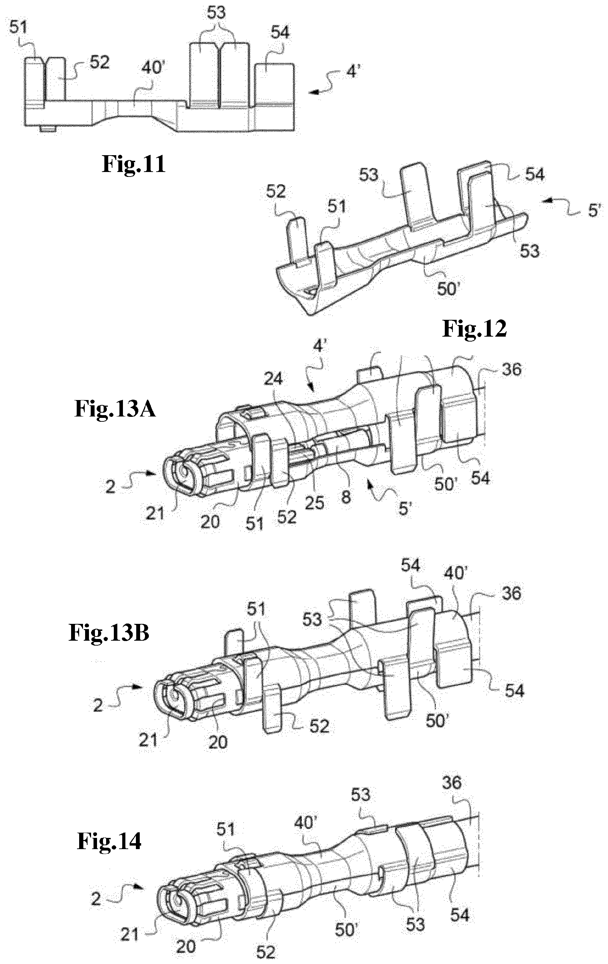

Les figures 11 et 12 montrent une variante de réalisation des deux demi-coques 4', 5' dont le corps creux 40', 50' de chacune supporte une des paires de pattes de sertissage 51, 52, 53, 54.

Les figures 13A et 13B montrent de manière similaire aux figures 10E et 10F l'assemblage de ces deux demi-coques 4', 5' entre elles par sertissage des pattes de sertissage 51, 52, 53, 54 autour à la fois du corps conducteur 20 et des contacts centraux 22, 23 du sous-ensemble 2, des fils avec leurs âmes 30, 31 et leurs isolants 32, 33, de la pièce d'adaptation d'impédance 8 et de la tresse métallique 35 du câble.

La figure 14 montre le connecteur 1 une fois monté sur le câble 3 avec les deux demi-coques 4', 5' assemblées entre elles.

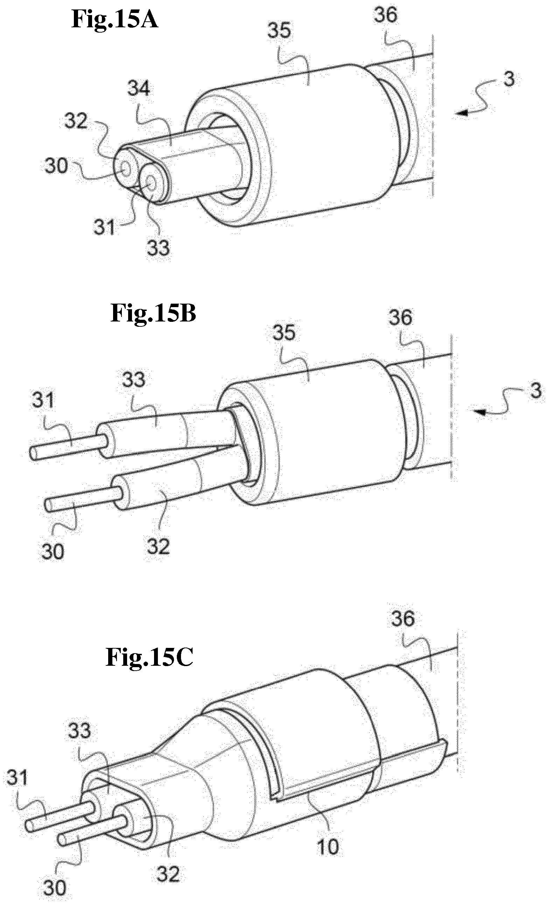

Les figures 15A à 15C montrent les différentes étapes de montage d'une pièce d'adaptation 8 selon l'invention dans un corps formant un contact de masse électrique 10 d'un câble 3 pour connecteur classique, sans demi-coques.

Le feuillard métallique 34 entoure initialement les isolants 32, 33 des âmes conductrices (figures 15A).

Après avoir dénudé ce feuillard 34 et les extrémités des âmes de fils 30, 31, on écarte ceux-ci l'un de l'autre (figure 15B).

Puis on procède à la mise en place de la pièce d'adaptation électrique comme précédemment, et on vient mettre autour un corps 10 formant un contact de masse (figure 15C).

Les figures 16 et 16A illustrent le montage qui en résulte.

La pièce métallique d'adaptation 8 permet de créer une continuité de masse, car la masse au plus près du câble 3, comme cela est symbolisé par les flèches en figures 16 et 16A. L'intégrité du signal électrique est donc préservée contrairement à la configuration selon l'état de l'art illustrée aux figures 17 et 17A, où l'on voit clairement qu'en l'absence de cette pièce, les parois à la masse 10 sont plus éloignées des âmes conductrices 30, 31, et par conséquent, l'adaptation d'impédance n'est pas optimisée.

Comme montré sur ces figures 16 et 16A, la pièce d'adaptation présente une zone de contact physique avec le corps formant contact de masse 10, ce qui garantit la continuité du signal électrique. Cette zone de contact pourra être obtenue par compression du corps formant contact de masse 10 sur la pièce 8 ou par soudage entre eux.

D'autres variantes et avantages de l'invention peuvent être réalisés sans pour autant sortir du cadre de l'invention.

L'invention n'est pas limitée aux exemples qui viennent d'être décrits ; on peut notamment combiner entre elles des caractéristiques des exemples illustrés au sein de variantes non illustrées.

## Revendications

1. Pièce (8) électriquement conductrice, destinée à garantir une adaptation d'impédance électrique lors de la connexion d'un connecteur avec un câble, comprenant au moins une paire de fils électriques torsadés, comprenant :
- une partie avant (80) dont la forme présente un profil extérieur continu et qui définit intérieurement deux logements cylindriques (82, 84) adaptés chacun pour loger la partie non dénudée d'un unique fil de câble ;
- une partie arrière (81), dans le prolongement de la partie avant, dont la forme présente un profil extérieur discontinu délimité par des ailettes (83, 85) de forme complémentaire à celle de la partie du fil (32, 33) d'un câble (3) non dénudée,
pièce dans laquelle les parties avant et arrière de la pièce sont configurées pour diminuer la distance entre les âmes conductrices des fils et la masse électrique du connecteur de sorte à recréer une masse électrique au plus près du câble.

2. Pièce selon la revendication 1, les logements (82, 84) étant jointifs avec un espace ouvert entre eux.

3. Pièce selon l'une des revendications 1 ou 2, le profil extérieur continu ayant sensiblement la forme d'un huit.

4. Ensemble comprenant :
- un connecteur (1), comprenant:
• un corps électriquement conducteur (20),
• un bloc isolant électrique (21), logé dans le corps conducteur,
• au moins deux contacts centraux (22, 23), insérés dans le bloc isolant, chaque contact central comprenant une partie de sertissage (24, 25),
- un câble électrique (3) comprenant au moins deux fils isolés constitués chacun d'une âme électriquement conductrice (31, 32) enrobée d'une couche d'isolant électrique (32, 33), et logés dans une gaine de protection (36), chaque âme conductrice étant serties à l'intérieur de la partie de sertissage d'un contact central ;
- une pièce (8) d'adaptation électrique selon l'une des revendications précédentes dont les logements (82, 84) entourent les isolants électriques des fils et les ailettes (83, 85) épousent avec contact les courbures de ces derniers.

5. Ensemble (1) selon la revendication 4, comprenant deux demi-coques électriquement conductrices assemblées entre elles, autour à la fois du corps conducteur, des contacts centraux, d'une partie du câble au-delà des extrémités dénudées des fils sertis, ainsi que de la pièce d'adaptation (8) qui est en contact électrique avec au moins l'une des deux demi-coques.

6. Ensemble (1) selon la revendication 4, comprenant un corps électriquement conducteur, formant contact de masse (10) positionné autour à la fois du corps conducteur, des contacts centraux, d'une partie du câble au-delà des extrémités dénudées des fils sertis, ainsi que de la pièce d'adaptation (8) en contact électrique avec le corps.

7. Ensemble (1) selon la revendication 6, la pièce d'adaptation (8) étant en contact physique avec le contact de masse (10) afin d'assurer la continuité électrique de la masse.

8. Procédé de montage d'une pièce électriquement conductrice (8) selon l'une des revendications 1 à 3, comprenant les étapes suivantes :
a'/ une fois que les extrémités des âmes de fils (30, 31) du câble sont dénudées et ceux-ci écartés l'un de l'autre, mise en place de la pièce (8) électriquement conductrice autour des âmes de fils (30, 31), de sorte que les logements (82, 84) de la partie avant de la pièce (8) épousent au plus près la forme des isolants électriques (32, 33) des fils de câble ;
a"/ : mise en compression de la pièce électriquement conductrice (8) autour des isolants (32, 33), de sorte à rapprocher les logements (82, 84) et les mettre en contact direct avec les isolants (32, 33), et de sorte que les ailettes (83, 85) épousent avec contact les courbures des isolants (32, 33);
a‴/ : mise en place de chacune des extrémités dénudées (30, 31) de fil du câble dans la partie de sertissage d'un contact central pré-monté du sous-ensemble.

## Patentansprüche

1. Elektrisch leitendes Bauteil (8), dazu bestimmt, bei der Verbindung eines Verbinders mit einem mindestens ein Paar von verdrillten Leitungsdrähten enthaltenden Kabel eine elektrische Impedanzanpassung zu garantieren, das enthält:
- einen vorderen Teil (80), dessen Form ein durchgehendes Außenprofil aufweist und der innen zwei zylindrische Aufnahmen (82, 84) definiert, die je geeignet sind, den nicht abisolierten Teil eines einzigen Kabeldrahts aufzunehmen;
- einen hinteren Teil (81), in der Verlängerung des vorderen Teils, dessen Form ein unterbrochenes Außenprofil aufweist, das von Flügeln (83, 85) komplementärer Form zu derjenigen des nicht abisolierten Teils des Drahts (32, 33) eines Kabels (3) begrenzt wird,
Bauteil, bei dem die vorderen und hinteren Teile des Bauteils konfiguriert sind, den Abstand zwischen den leitenden Seelen der Drähte und der elektrischen Masse des Verbinders zu verringern, um eine elektrische Masse so nahe wie möglich zum Kabel wiederherzustellen.

2. Bauteil nach Anspruch 1, wobei die Aufnahmen (82, 84) mit einem offenen Raum zwischen ihnen nebeneinander liegen.

3. Bauteil nach einem der Ansprüche 1 oder 2, wobei das durchgehende Außenprofil im Wesentlichen die Form einer Acht hat.

4. Einheit, die enthält:
- einen Verbinder (1), der enthält:
• einen elektrisch leitenden Körper (20),
• einen im leitenden Körper untergebrachten elektrischen Isolierblock (21),
• mindestens zwei in den Isolierblock eingefügte zentrale Kontakte (22, 23), wobei jeder zentrale Kontakt einen Einpressteil (24, 25) enthält,
- ein elektrisches Kabel (3), das mindestens zwei isolierte Drähte enthält, die je aus einer elektrisch leitenden Seele (31, 32) umhüllt von einer Schicht eines elektrischen Isolators (32, 33) bestehen und in einer Schutzhülle (36) untergebracht sind, wobei jede leitende Seele im Inneren des Einpressteils eines zentralen Kontakts eingepresst wird;
- ein Bauteil (8) zur elektrischen Anpassung nach einem der vorhergehenden Ansprüche, dessen Aufnahmen (82, 84) die elektrischen Isolatoren der Drähte umgeben und die Flügel (83, 85) sich den Krümmungen dieser letzteren mit Kontakt anpassen.

5. Einheit (1) nach Anspruch 4, die zwei zusammengebaute elektrisch leitende Halbschalen um sowohl den leitenden Körper, die zentralen Kontakte, einen Teil des Kabels jenseits der abisolierten Enden der eingepressten Drähte, sowie das Anpassungsbauteil (8) herum enthält, das mit mindestens einer der zwei Halbschalen in elektrischem Kontakt ist.

6. Einheit (1) nach Anspruch 4, die einen elektrisch leitenden Körper enthält, der einen Massekontakt (10) bildet, der sowohl um den leitenden Körper, die zentralen Kontakte, einen Teil des Kabels jenseits der abisolierten Enden der eingepressten Drähte, sowie um das Anpassungsbauteil (8) in elektrischem Kontakt mit dem Körper herum positioniert ist.

7. Einheit (1) nach Anspruch 6, wobei das Anpassungsbauteil (8) mit dem Massekontakt (10) in physikalischem Kontakt ist, um die elektrische Kontinuität der Masse zu gewährleisten.

8. Verfahren zur Montage eines elektrisch leitenden Bauteils (8) nach einem der Ansprüche 1 bis 3, das die folgenden Schritte enthält:
a'/ wenn die Enden der Drahtseelen (30, 31) des Kabels abisoliert und diese voneinander abgespreizt sind, Einsetzen des elektrisch leitenden Bauteils (8) um Drahtseelen (30, 31) herum, so dass die Aufnahmen (82, 84) des vorderen Teils des Bauteils (8) sich der Form der elektrischen Isolatoren (32, 33) der Kabeldrähte so nahe wie möglich anpassen;
a"/ Komprimieren des elektrisch leitenden Bauteils (8) um die Isolatoren (32, 33) herum, um die Aufnahmen (82, 84) anzunähern und sie in direkten Kontakt mit den Isolatoren (32, 33) zu bringen, und damit die Flügel (83, 85) sich mit Kontakt an die Krümmungen der Isolatoren (32, 33) anpassen;
a‴/ Einsetzen jedes der abisolierten Drahtenden (30, 31) des Kabels in den Einpressteil eines vormontierten zentralen Kontakts der Teileinheit.

## Claims

1. Electrically conductive part (8), intended to provide electrical impedance matching when connecting a connector with a cable, comprising at least one pair of twisted electrical wires, comprising:
- a front portion (80), the shape of which has a continuous outer profile and which defines on the inside two cylindrical housings (82, 84), each of which is suitable for housing the unstripped portion of a single cable wire;
- a rear portion (81), extending from the front portion, the shape of which has a discontinuous outer profile defined by fins (83, 85) taking a shape that is complementary to that of the unstripped portion of the wire (32, 33) of a cable (3),
in which part the front and rear portions of the part are configured to decrease the distance between the conductive cores of the wires and the electrical ground of the connector so as to recreate an electrical ground as close as possible to the cable.

2. Part according to Claim 1, the housings (82, 84) being contiguous with an open space between them.

3. Part according to either of Claims 1 and 2, the continuous outer profile substantially taking the shape of an eight.

4. Assembly comprising:
- a connector (1), comprising:
• an electrically conductive body (20);
• an electrically insulating block (21), housed in the conductive body;
• at least two central contacts (22, 23), which are inserted into the insulating block, each central contact comprising a crimping portion (24, 25);
- an electrical cable (3) comprising at least two insulating wires, each consisting of an electrically conductive core (31, 32) coated with an electrically insulating layer (32, 33), and which are housed in a protective sheet (36), each conductive core being crimped inside the crimping portion of a central contact;
- an electrical matching part (8) according to one of the preceding claims, the housings (82, 84) of which surround the electrical insulators of the wires and the fins (83, 85) conform to the curves of the latter while making contact therewith.

5. Assembly (1) according to Claim 4, comprising two electrically conductive half-shells that are assembled together around the conductive body, the central contacts, a portion of the cable beyond the stripped ends of the crimped wires and the matching part (8), which makes electrical contact with at least one of the two half-shells.

6. Assembly (1) according to Claim 4, comprising an electrically conductive body, forming a ground contact (10), which is positioned around the conductive body, the central contacts, a portion of the cable beyond the stripped ends of the crimped wires and the matching part (8), which makes electrical contact with the body.

7. Assembly (1) according to Claim 6, the matching part (8) being in physical contact with the ground contact (10) in order to ensure electrical ground continuity.

8. Method for mounting an electrically conductive part (8) according to one of Claims 1 to 3, comprising the following steps:
a'/ once the ends of the wire cores (30, 31) of the cable are stripped and the latter separated from one another, the electrically conductive part (8) is placed around the wire cores (30, 31) such that the housings (82, 84) of the front portion of the part (8) conform to the shape of the electrical insulators (32, 33) of the cable wires as closely as possible;
a"/ the electrically conductive part (8) is pressed around the insulators (32, 33) so as to bring the housings (82, 84) closer together and to bring them into direct contact with the insulators (32, 33), and such that the fins (83, 85) conform to the curves of the insulators (32, 33) while making contact therewith;
a‴/ each of the stripped wire ends (30, 31) of the cable is placed in the crimping portion of a pre-mounted central contact of the subassembly.
